(19) **Europäisches Patentamt / European Patent Office / Office européen des brevets**

(11) **EP 4 633 221 B1**

(12) **EUROPEAN PATENT SPECIFICATION**

(45) Date of publication and mention
of the grant of the patent:
**20.05.2026 Bulletin 2026/21**

(21) Application number: **25168765.3**

(22) Date of filing: **07.04.2025**

(51) International Patent Classification (IPC):
$H04W\ 24/00$ (2009.01)    $B60L\ 58/10$ (2019.01)
$B60L\ 58/18$ (2019.01)    $G01R\ 31/36$ (2020.01)
$G01R\ 31/371$ (2019.01)    $G01R\ 31/382$ (2019.01)
$H04W\ 36/00$ (2009.01)    $H04W\ 48/00$ (2009.01)
$H04W\ 72/00$ (2023.01)

(52) Cooperative Patent Classification (CPC):
H04W 36/00; B60L 58/10; B60L 58/18;
G01R 31/371; H04W 24/00; H04W 48/00;
H04W 72/02; H04W 72/542

(54) **COMMUNICATION CONTROL DEVICE, COMMUNICATION CONTROL SYSTEM, AND COMMUNICATION CONTROL METHOD**

KOMMUNIKATIONSSTEUERUNGSVORRICHTUNG, KOMMUNIKATIONSSTEUERUNGSSYSTEM UND KOMMUNIKATIONSSTEUERUNGSVERFAHREN

DISPOSITIF DE COMMANDE DE COMMUNICATION, SYSTÈME DE COMMANDE DE COMMUNICATION ET PROCÉDÉ DE COMMANDE DE COMMUNICATION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **10.04.2024 JP 2024063212**

(43) Date of publication of application:
**15.10.2025 Bulletin 2025/42**

(73) Proprietor: **Yazaki Corporation**
**Tokyo 108-0075 (JP)**

(72) Inventor: **Masuda, Satono**
**Susono-shi, Shizuoka 410-1194 (JP)**

(74) Representative: **Grünecker Patent- und Rechtsanwälte**
**PartG mbB**
**Leopoldstraße 4**
**80802 München (DE)**

(56) References cited:
WO-A1-2023/243420    US-A1- 2022 353 650
US-A1- 2023 194 623    US-A1- 2025 116 710
US-B2- 11 867 766

**Description**

The present invention relates to a communication control device, a communication control system, and a communication control method.

Hitherto, a wireless battery management system (BMS) has been proposed for wirelessly controlling a plurality of batteries installed in a vehicle. JP 2024-7900 A discloses a wireless communication system built in a battery pack of a vehicle. The wireless communication system disclosed in JP 2024-7900 A includes a battery management device in a battery pack and a plurality of battery data devices wirelessly communicable with the battery management device, and manages a state of each battery module in the battery pack.

US 2022/253650 A1 relates to a wireless vehicular communication device that may perform channel measurements within two frequency bands. A "channel map" specifying resources allocated across a geographic area is utilized.

WO 2023/243420 A1 relates to wireless communication between a control device and a plurality of management devices of respective battery units. The management devices may communicate using two different directivities, i.e. the wireless signal may be emitted in two different directions. Based on channel measurements, it is determined which directivity is best for respective channels.

In a battery pack of an electric vehicle or the like, a communication environment may be degraded due to occurrence of diffusion reflection of an electric wave or the like. When communication is performed in such an environment, a packet error rate of communication data increases, necessary information cannot be transmitted and received, and reliability of the communication system is compromised.

The present invention has been made in view of such a problem in the related art. Further, an object of the present invention is to provide a communication control device that can achieve highly reliable communication in a battery pack installed in a vehicle.

The invention is defined by the independent claims. The dependent claims describe advantageous embodiments.

BRIEF DESCRIPTION OF THE DRAWINGS

Fig. 1 is a diagram illustrating a configuration of a communication control system according to the present embodiment.
Fig. 2 is a diagram for describing a channel map applied to the communication control system according to the present embodiment.
Fig. 3 is a block diagram illustrating a functional configuration of a communication control device according to the present embodiment.

Fig. 4 is a diagram for describing communication environment determination in the communication control system according to the present embodiment.
Fig. 5 is a diagram illustrating an example of communication environment information of the communication control device according to the present embodiment.
Fig. 6 is a diagram for describing a channel map applied to the communication control system according to the present embodiment.
Fig. 7 is a flowchart illustrating an example of processing of the communication control device according to the present embodiment.

DETAILED DESCRIPTION OF THE INVENTION

With reference to the drawings, a communication control system 10 and a communication control device 100 according to the present embodiment are described below in detail. Note that the dimensional ratios in the drawings are exaggerated for explanatory purposes, and may differ from the actual ratios. Further, in the following drawings, the same or similar parts are denoted with the same or similar reference symbols.

(Battery Management System)

A large number of batteries such as lithium-ion batteries are installed in an electric vehicle (EV) or a hybrid electric vehicle (HEV), and it is desired to manage those batteries and use energy efficiently. As a system that manages the batteries, a battery management system (BMS) is widely used. The battery management system monitors and controls a charging/discharging state of the battery and cell balancing. With this, the usage efficiency of the battery can be improved, and the lifespan of the battery itself can be extended.

The battery management system exists as one that uses wired communication via a cable such as a wire harness and one that uses wireless communication. In the case of wired communication, a connection configuration becomes complex depending on a cable to be used. Further, when a cable weight is increased, a vehicle weight is increased, resulting in a shorter travel distance. Thus, there is an increasing need for a wireless BMS that can eliminate a cable.

Meanwhile, when the battery management system is achieved by using wireless communication, a communication environment is degraded due to occurrence of diffusion reflection of an electric wave or the like in a battery pack. When communication is performed in such an environment, a packet error rate of communication data increases, necessary information cannot be transmitted and received, and reliability is compromised. The communication control system 10 according to the present embodiment is proposed to achieve the communication control device 100 and the communication control system 10 that can achieve highly reliable communication in such a battery pack.

(Configuration of Communication Control System 10)

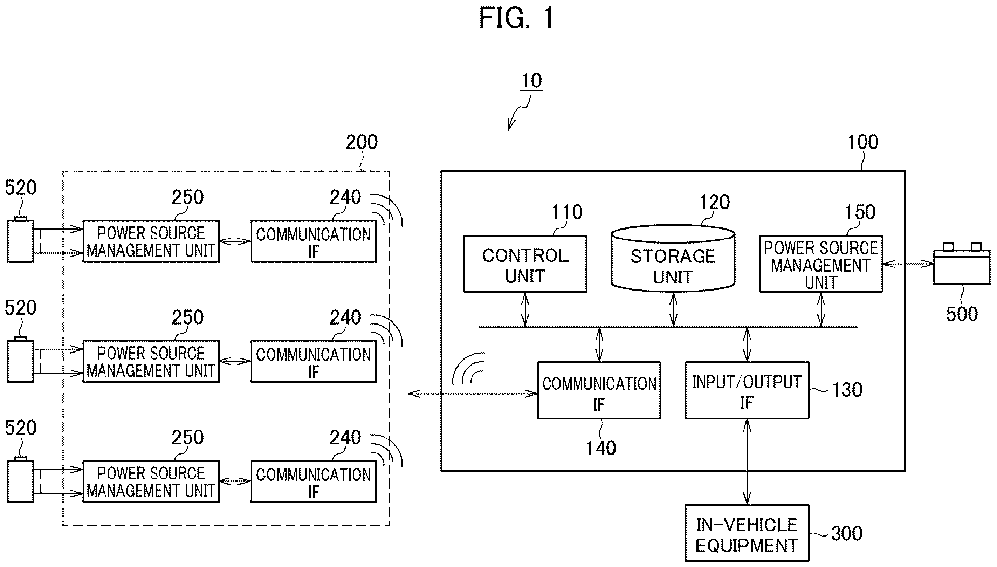

Fig. 1 is a diagram illustrating a configuration of the communication control system 10 according to the present embodiment. The communication control system 10 is the communication control system 10 including a battery pack installed in a vehicle, a peripheral management device 200 that manages a battery in a periphery, and the communication control device 100 that controls wireless communication with the peripheral management device 200 in the battery pack.

In the communication control system 10, data is exchanged via wireless communication between the peripheral management device 200 and the communication control device 100. The peripheral management device 200 includes a power source management unit 250 managing a battery 520 in a periphery and a communication IF 240.

In the present embodiment, the communication control device 100 is configured by a general microcomputer including a control unit 110, a storage unit 120, an input/output interface (IF) 130, a communication IF 140, and a power source management unit 150.

For example, the control unit 110 operates an operating system, and controls the communication control device 100 as a whole. Moreover, the control unit 110 is operated based on a program stored in the storage unit 120, and executes each of functions of the communication control device 100 that are described later. Note that the program is not limited to one stored in the storage unit 120, and may be stored in a read only memory (ROM) or the like in the communication control device 100, for example.

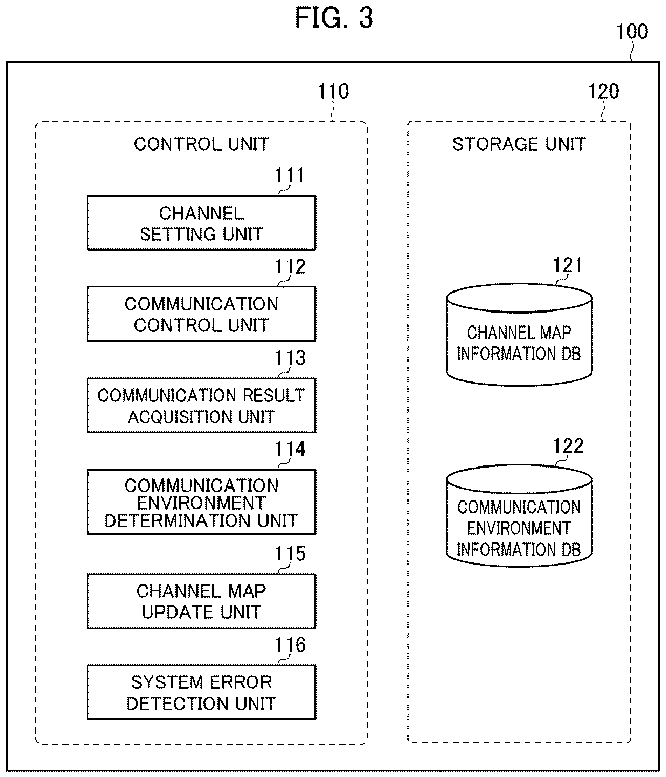

As illustrated in Fig. 3, the storage unit 120 stores, as data, information contained in a channel map information database (DB) 121 and a communication environment information DB 122. Note that each piece of the data may be stored in one or a plurality of storage units 120. For example, there may be adopted a configuration in which one storage unit 120 may be divided into regions in which each piece of the data is stored. Alternatively, the data may be distributed and stored in a plurality of storage devices that are physically installed in separate locations.

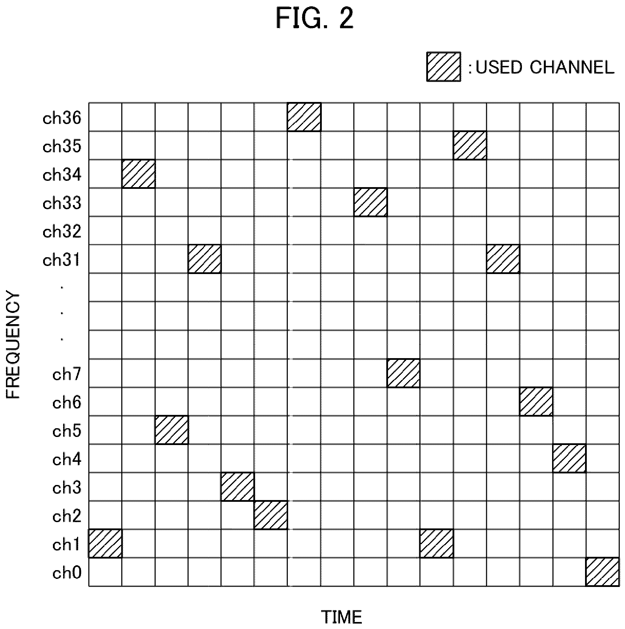

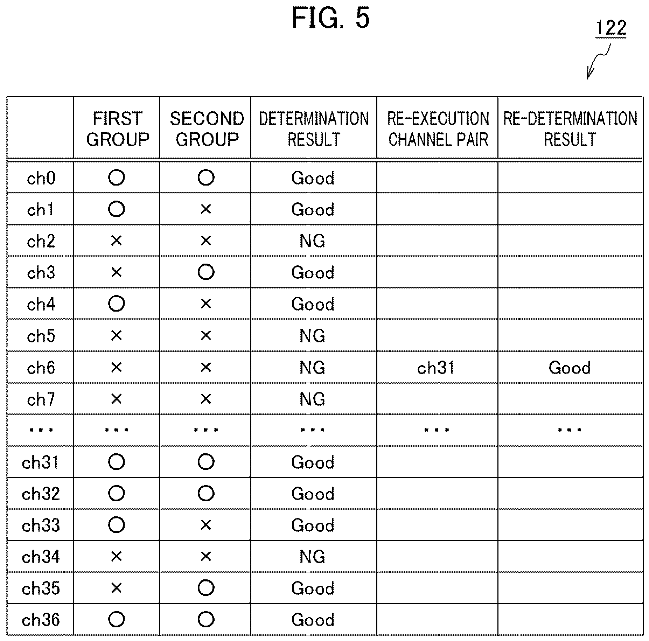

The channel map information DB 121 stores information relating to a channel map as illustrated in Fig. 2. Further, the communication environment information DB 122 stores communication environment information as illustrated in Fig. 5. Details of the communication environment information are described later.

For example, the input/output IF 130 is a constituent element (interface) for exchanging data with in-vehicle equipment 300. The in-vehicle equipment 300 corresponds to in-vehicle equipment such as a fan and a heater that is installed in a vehicle.

The communication IF 140 is an interface that enables communication with the communication IF 240 of the peripheral management device 200. The communication in the present embodiment employs a method that utilizes a plurality of channels and changes the channels to be used over time through frequency hopping.

Fig. 2 is a diagram for describing the channel map applied to the communication control system 10 according to the present embodiment. In the present embodiment, as the channels to be used for data communication, there are 37 channels that are divided into ch0 to ch36 according to frequency. In the communication method applied in the present embodiment, it is known that some of the channels have a high packet error rate while others have a low packet error rate.

Thus, when a channel with a high packet error rate is used at the time of frequency hopping, the number of packet errors is increased. From those considerations, it is required to minimize a packet error in order to accurately transmit and receive a voltage of a battery cell. However, as described above, the environment inside the battery pack is prone to a packet error. Thus, in the communication in the battery management system, it is required to avoid a channel with a high packet error rate and reduce a packet error rate.

(Functional Configuration of Communication Control Device 100)

Fig. 3 is a block diagram illustrating a functional configuration of the communication control device 100 according to the present embodiment. In the present embodiment, the control unit 110 of the communication control device 100 includes a channel setting unit 111, a communication control unit 112, a communication result acquisition unit 113, a communication environment determination unit 114, a channel map update unit 115, and a system error detection unit 116 as functions.

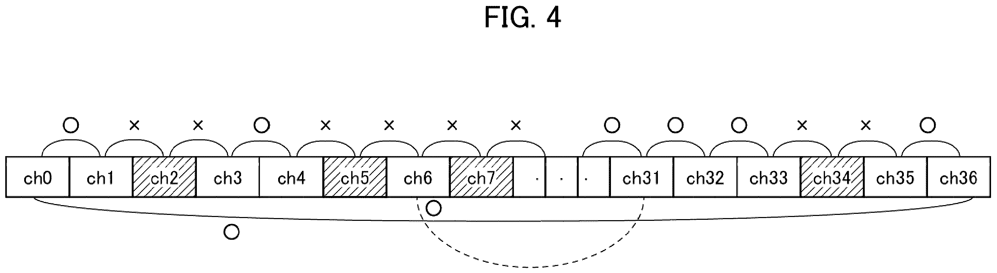

The channel setting unit 111 sets two channels as a primary selection communication group, the two channels being selected from the plurality of channels used for wireless communication. Specifically, the channel setting unit 111 sets two adjacent channels as a primary selection communication group. For example, in the example illustrated in Fig. 4, ch1 and ch0 are paired, and are set as a primary selection communication group. Similarly, ch2 and ch1 are paired, and are set as a primary selection communication group. Subsequently, ch3 to ch36 are similarly paired with the preceding channels, and are set as primary selection communication groups. Note that ch0 and ch36 are paired, and are set as a primary selection communication group.

The communication control unit 112 executes communication in the primary selection communication group. Specifically, the communication with the peripheral management device 200 is executed by the primary selection communication group in which the two channels are set by the channel setting unit 111.

The communication result acquisition unit 113 acquires a communication result in the primary selection communication group. Further, the communication result acquisition unit 113 stores, in the communication environment information DB 122, the communication result being acquired. Fig. 4 is a diagram for describing communication environment determination in the communication control system 10 according to the present embodiment. Further, Fig. 5 is a diagram illustrating an example of the communication environment information of the communication control device 100 according to the present embodiment.

For example, as illustrated in Fig. 4, the communication is executed by the primary selection communication group including the preceding and following channels, and the quality of the communication environment is acquired as a communication result for each of the channels as illustrated in Fig. 4. Note that, in Fig. 4, the symbol "○" is schematically shown as an example of a case in which the communication environment is good (satisfactory), and the symbol "×" is schematically shown as an example of a case in which the communication environment is poor (not satisfactory).

**In** the present embodiment, the quality of the communication environment is determined based on a packet error rate. The packet error rate is calculated as a value obtained by dividing the number of cyclic redundancy check (CRC) errors and timeout errors in a packet by the total number of transmitted packets. The communication result acquisition unit 113 determines that the communication environment is poor when the packet error rate exceeds a predetermined threshold value, and determines that the communication environment is good when the packet error rate does not exceed the threshold value.

In the example illustrated in Fig. 5, the communication result in the primary selection communication group including each channel and the preceding channel is stored in the column "first group," and the communication result in the primary selection communication group including each channel and the following channel is stored in the column "second group."

The communication environment determination unit 114 determines the communication environment of the channel, based on the communication result. Specifically, the communication environment determination unit 114 determines the communication environment of the channel, based on the communication results of the two primary selection communication groups to which the channel belongs. When at least one of the communication results of the two primary selection communication groups to which the channel belongs is satisfactory, the communication environment determination unit 114 determines that the communication environment of the channel is satisfactory. Further, the communication environment determination unit 114 stores the determination result in the communication environment information DB 122.

In the example illustrated in Fig. 5, with regard to the channel for which the symbol "○" is stored in at least one of the first group, which is the primary selection communication group with the preceding channel, and the second group, which is the primary selection communication group with the following channel, the result "Good" is stored in the column "determination result." Meanwhile, with regard to the channel for which the symbol "×" is stored in both the first group and the second group, the result "NG" is stored in the column "determination result."

The channel map update unit 115 updates the channel map indicating whether the channel is communicable, based on a result determined by the communication environment determination unit 114.

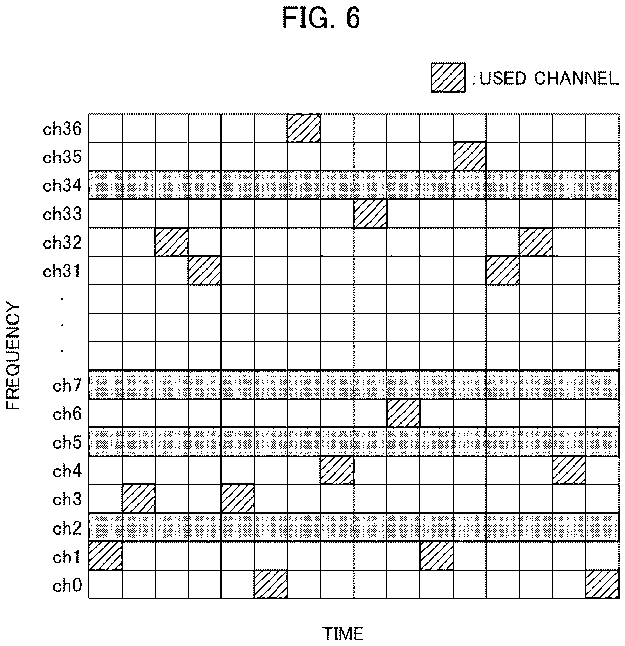

Fig. 6 is a diagram for describing the channel map applied to the communication control system 10 according to the present embodiment. In the example illustrated in Fig. 6, it is determined that the communication cannot be executed in ch2, ch5, ch7, and ch34, and hence the information indicating the determination is schematically illustrated in the drawing.

(Re-execution of Communication Environment Determination)

As a result of determining the communication result in the primary selection communication group, when three or more consecutive channels are determined to have a poor communication environment, a channel that has a satisfactory communication environment may also be determined as having a poor communication environment. For example, in the example illustrated in Fig. 4, ch6 itself has a satisfactory communication environment. However, the preceding and following channels have a poor communication environment. Thus, ch6 is determined to have a poor communication environment in the determination result for the primary selection communication group.

Thus, in the communication control device 100 according to the present embodiment, such a channel and a channel determined to have a satisfactory communication environment are set as a second selection communication group, and determination on the communication environment is executed again.

Specifically, when it is determined that the communication environment of the channel is not satisfactory, and the communication environment of the other channels in the two primary selection communication groups to which the channel belongs is not satisfactory, the channel setting unit 111 sets a second selection communication group. Further, the channel setting unit 111 sets the second selection communication group including another channel that is determined to have a satisfactory communication environment by the communication environment determination unit 114.

Further, the communication control unit 112

executes communication in the second selection communication group. Further, the communication result acquisition unit 113 acquires the communication result in the second selection communication group, and stores the communication result in the communication environment information DB 122. Further, the communication environment determination unit 114 determines the communication environment of the channel, based on the communication result, and stores the communication environment in the communication environment information DB 122. Moreover, the channel map update unit 115 updates the channel map indicating whether the channel is communicable, based on a result determined by the communication environment determination unit 114.

Specifically, in the example illustrated in Fig. 5, the second selection communication group is set so that ch6 and ch31 form a re-execution channel pair. The communication control unit 112 executes communication in the second selection communication group, acquires a communication result, and stores the communication result in the communication environment information DB 122. In the example illustrated in Fig. 5, the symbol "○" is stored as a re-execution result. Moreover, the communication environment determination unit 114 determines a channel communication environment, based on the communication result, and stores the channel communication environment in the communication environment information DB 122. In the example illustrated in Fig. 5, the result "Good" is stored in the column "re-determination result" for ch6.

With this, the communication control device 100 re-executes communication in the second selection communication group including the channel determined to have a communication environment that is not satisfactory in the primary selection communication group and the channel determined to have a satisfactory communication environment, and thus can determine the communication environment more accurately.

(System Error)

Further, in the present embodiment, the system error detection unit 116 detects a system error when a natural number m satisfies Expression (1) given below. Further, the system error detection unit 116 performs control to prevent the communication control unit 112 from executing communication when the natural number m satisfies Expression (1) given below.

$$m \geq (n+1)/2 \cdots (1)$$

where

    n is a natural number indicating the number of channels, and
    m is a natural number indicating the number of channels that are not communicable and are indicated in the channel map.

For example, in the communication where the number of channels is 37, when 19 or more channels have a poor communication environment, determination on the communication environment according to the present embodiment cannot be executed in some cases. Thus, when accurate determination on the communication environment cannot be executed, the communication control device 100 according to the present embodiment detects a system error, and does not execute communication. With this, erroneous communication can be avoided, and reliability of the communication environment can be improved.

(Overview of Processing Flow of Communication Control Device 100)

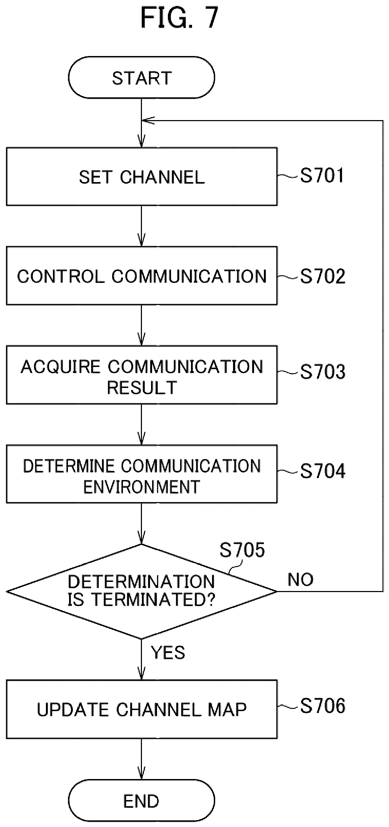

Next, with reference to the flowchart illustrated in Fig. 7, the flow of the processing in the communication control device 100 is described. A series of operations of the communication control device 100 that is illustrated in the flowchart in Fig. 7 is started when the communication control device 100 is activated, and the processing is terminated upon completion of the operations. Further, in the flowchart illustrated in Fig. 7, the processing is also terminated upon a power-off or an interruption due to processing termination. Further, in the following description relating to the flowchart, the contents similar to the contents given above in the description for the communication control system 10 and the communication control device 100 are omitted or simplified.

In Step S701, the channel setting unit 111 sets two channels as a primary selection communication group, the two channels being selected from the plurality of channels used for wireless communication. Specifically, the channel setting unit 111 sets two adjacent channels as a primary selection communication group. For example, in the example illustrated in Fig. 4, ch1 and ch0 are paired, and are set as a primary selection communication group. Similarly, ch2 and ch1 are paired, and are set as a primary selection communication group. Subsequently, ch3 to ch36 are similarly paired with the preceding channels, and are set as primary selection communication groups. Note that ch0 and ch36 are paired, and are set as a primary selection communication group. After that, the processing proceeds to Step S702.

In Step S702, the communication control unit 112 executes communication in the primary selection communication group. Specifically, the communication with the peripheral management device 200 is executed by the primary selection communication group in which the two channels are set by the channel setting unit 111. After that, the processing proceeds to Step S703.

In Step S703, the communication result acquisition unit 113 acquires the communication result in the primary selection communication group. Further, the communication result acquisition unit 113 stores, in the communication environment information DB 122, the communication result being acquired. After that, the processing proceeds to Step S704.

In Step S704, the communication environment determination unit 114 determines the communication environment of the channel, based on the communication result. Specifically, the communication environment determination unit 114 determines the communication environment of the channel, based on the communication results of the two primary selection communication groups to which the channel belongs. When at least one of the communication results of the two primary selection communication groups to which the channel belongs is satisfactory, the communication environment determination unit 114 determines that the communication environment of the channel is satisfactory. Further, the communication environment determination unit 114 stores the determination result in the communication environment information DB 122. After that, the processing proceeds to Step S705.

In Step S705, the control unit 110 determines whether the determination on the communication environment of the channel is terminated. Specifically, the control unit 110 executes determination, based on whether the communication is executed in the primary selection communication group for all the channels and the communication in the second selection communication group is completed. **In** Step S705, when the control unit 110 determines that determination on the communication environment of the channel is terminated (Step S705: YES), the processing proceeds to Step S706. **In** contrast, in Step S705, when the control unit 110 determines that determination on the communication environment of the channel is not terminated (Step S705: NO), the processing returns to Step S701, and the processing is repeated from Step S701.

**In** Step S706, the channel map indicating whether the channel is communicable is updated based on a result determined by the communication environment determination unit 114. After that, the processing of determining the communication environment is terminated. After that, the communication control device 100 selects a channel to be used by removing the channel having a communication environment that is not satisfactory, based on the information relating to the channel map being updated, and executes communication in the battery pack.

As described above, the communication control device 100 is the communication control device 100 that controls wireless communication in a battery pack installed in a vehicle. The communication control device 100 includes the channel setting unit 111 that sets two channels as a primary selection communication group, the two channels being selected from a plurality of channels used for wireless communication. Further, the communication control device 100 includes the communication control unit 112 that executes communication in the primary selection communication group. Further, the communication control device 100 includes the communication result acquisition unit 113 that acquires a communication result in the primary selection communication group. Further, the communication control device 100 includes the communication environment determination unit 114 that determines a communication environment of the channel, based on the communication result. Moreover, the communication control device 100 includes the channel map update unit 115 that updates a channel map indicating whether the channel is communicable, based on a result determined by the communication environment determination unit 114.

With this, the communication control device 100 can achieve highly reliable communication in a battery pack installed in a vehicle.

Further, the communication environment determination unit 114 may determine the communication environment of the channel, based on the communication results of the two primary selection communication groups to which the channel belongs. With this, the communication control device 100 can reflect, in the determination on the communication environment of the channel, the communication results of the preceding and following channels, and can determine the communication environment more accurately.

Further, when at least one of the communication results of the two primary selection communication groups to which the channel belongs is satisfactory, the communication environment determination unit 114 may determine that the channel has a satisfactory communication environment. With this, the communication control device 100 can reflect, in the determination on the communication environment of the channel, the communication result indicating that the communication environment is satisfactory, and can determine the communication environment more accurately.

Further, when it is determined that the communication environment of the channel is not satisfactory, and the communication environment of the other channels in the two primary selection communication groups to which the channel belongs is not satisfactory, the channel setting unit 111 may set a second selection communication group. The second selection communication group may be set to include the communication channel and another channel that is determined to have a satisfactory communication environment by the communication environment determination unit 114. Further, the communication control unit 112 may execute communication in the second selection communication group. Further, the communication result acquisition unit 113 may acquire the communication result in the second selection communication group. Further, the communication environment determination unit 114 may determine the communication environment of the channel, based on the communication result. Moreover, the channel map update unit 115 may update the channel map indicating whether the channel is communicable, based on a result determined by the communication environment determination unit 114.

With this, the communication control device 100 re-executes communication in the second selection communication group including the channel determined to have a communication environment that is not satisfactory in the primary selection communication group and the channel determined to have a satisfactory communication environment, and thus can determine the communication environment more accurately.

Further, the communication control device 100 may further include the system error detection unit 116. The system error detection unit 116 may detect a system error when a natural number m satisfies Expression (1) given below. Further, the system error detection unit 116 may perform control to prevent the communication control unit 112 from executing communication when the natural number m satisfies Expression (1) given below.

$$m \geq (n+1)/2 \cdots (1)$$

where

n is a natural number indicating the number of channels, and
m is a natural number indicating the number of channels that are not communicable and are indicated in the channel map.

Thus, when accurate determination on the communication environment cannot be executed, the communication control device 100 according to the present embodiment detects a system error, and does not execute communication. With this, erroneous communication can be avoided, and reliability of the communication environment can be improved.

(Other Embodiments)

While the embodiment is described in detail with reference to the drawings, the present embodiment is not limited by the contents described in the embodiment described above. Further, the constituent elements described above include an element that can easily be conceived by a person skilled in the art and substantially the same element. Moreover, the configurations described above may be combined as appropriate. Further, various omissions, substitutions, or modifications may be made to the configurations without departing from the gist of the embodiment.

Further, a computer program (communication control program) for causing a computer to execute the processing (communication control method) of the communication control device 100 described above and a computer-readable recording medium that records the program are included within the scope of the present embodiment. Herein, the type of the computer-readable recording medium is freely selectable. Further, the computer program described above is not limited to one recorded in the recording medium described above, and may be transmitted via an electric communication line, a wireless or wired communication line, a network represented by the Internet, or the like.

The features of the communication control device 100, the communication control system 10, and the communication control method are described below.

The communication control device 100 according to a first aspect is the communication control device 100 that controls wireless communication in a battery pack installed in a vehicle. The communication control device 100 includes the channel setting unit 111 that sets two channels as a primary selection communication group, the two channels being selected from a plurality of channels used for wireless communication. Further, the communication control device 100 includes the communication control unit 112 that executes communication in the primary selection communication group. Further, the communication control device 100 includes the communication result acquisition unit 113 that acquires a communication result in the primary selection communication group. Further, the communication control device 100 includes the communication environment determination unit 114 that determines a communication environment of the channel, based on the communication result. Moreover, the communication control device 100 includes the channel map update unit 115 that updates a channel map indicating whether the channel is communicable, based on a result determined by the communication environment determination unit 114.

According to the configuration described above, the communication control device 100 can achieve highly reliable communication in a battery pack installed in a vehicle.

The communication environment determination unit 114 of the communication control device 100 according to a second aspect may determine the communication environment of the channel, based on the communication results of the two primary selection communication groups to which the channel belongs.

According to the configuration described above, the communication control device 100 can reflect, in the determination on the communication environment of the channel, the communication results of the preceding and following channels, and can determine the communication environment more accurately.

The communication environment determination unit 114 of the communication control device 100 according to a third aspect may determine that the communication environment of the channel is satisfactory when at least one of the communication results of the two primary selection communication groups to which the channel belongs is satisfactory.

According to the configuration described above, the communication control device 100 can reflect, in the determination on the communication environment of the channel, the communication result indicating that the communication environment is satisfactory, and can determine the communication environment more accurately

Further, according to a fourth aspect, when it is determined that the communication environment of the channel is not satisfactory, and the communication environment of the other channels in the two primary selection communication groups to which the channel belongs is not satisfactory, the channel setting unit 111 may set a second selection communication group. The second selection communication group may be set to include the communication channel and another channel that is determined to have a satisfactory communication environment by the communication environment determination unit 114. Further, the communication control unit 112 may execute communication in the second selection communication group. Further, the communication result acquisition unit 113 may acquire the communication result in the second selection communication group. Further, the communication environment determination unit 114 may determine the communication environment of the channel, based on the communication result. Moreover, the channel map update unit 115 may update the channel map indicating whether the channel is communicable, based on a result determined by the communication environment determination unit 114.

According to the configuration described above, the communication control device 100 re-executes communication in the second selection communication group including the channel determined to have a communication environment that is not satisfactory in the primary selection communication group and the channel determined to have a satisfactory communication environment. With this, the communication control device 100 can determine the communication environment more accurately.

The communication control device 100 according to a fifth embodiment may further include the system error detection unit 116. The system error detection unit 116 may detect a system error when a natural number m satisfies Expression (1) given below. Further, the system error detection unit 116 may perform control to prevent the communication control unit 112 from executing communication when the natural number m satisfies Expression (1) given below.

$$m \geq (n+1)/2 \cdots (1)$$

where

n is a natural number indicating the number of channels, and
m is a natural number indicating the number of channels that are not communicable and are indicated in the channel map.

According to the configuration described above, when accurate determination on the communication environment cannot be executed, the communication control device 100 detects a system error, and does not execute communication. With this, erroneous communication can be avoided, and reliability of the communication environment can be improved.

The communication control system 10 according to a sixth aspect is the communication control system 10 including a battery pack installed in a vehicle and the communication control device 100 that controls wireless communication in the battery pack. The communication control device 100 includes the channel setting unit 111 that sets two channels as a primary selection communication group, the two channels being selected from a plurality of channels used for wireless communication. Further, the communication control device 100 includes the communication control unit 112 that executes communication in the primary selection communication group. Further, the communication control device 100 includes the communication result acquisition unit 113 that acquires a communication result in the primary selection communication group. Further, the communication control device 100 includes the communication environment determination unit 114 that determines a communication environment of the channel, based on the communication result. Moreover, the communication control device 100 includes the channel map update unit 115 that updates a channel map indicating whether the channel is communicable, based on a result determined by the communication environment determination unit 114.

According to the configuration described above, the communication control system 10 can achieve highly reliable communication in a battery pack installed in a vehicle.

The communication control method according to a seventh aspect is a communication control method that is executed by a computer to control wireless communication in a battery pack installed in a vehicle. The communication control method includes setting two channels as a primary selection communication group, the two channels being selected from a plurality of channels used for wireless communication. Further, the communication control method includes executing communication in the primary selection communication group. Further, the communication control method includes acquiring a communication result in the primary selection communication group. Further, the communication control method includes determining a communication environment of the channel, based on the communication result. Moreover, the communication control method includes updating a channel map indicating whether the channel is communicable, based on a result being determined.

According to the configuration described above, the communication control method can achieve highly reliable communication in a battery pack installed in a vehicle.

Although the present invention has been described above by reference to the embodiment, the present invention is not limited to those and the configuration of parts can be replaced with any configuration having a similar function, as long as they lie within the scope of the claims.

**Claims**

1. A communication control device (100) configured to control wireless communication with a peripheral management device (200) in a battery pack installed in a vehicle, **characterized by** comprising:

    a channel setting unit (111) configured to set two channels as a primary selection communication group, the two channels being selected from a plurality of channels used for the wireless communication;
    a communication control unit (112) configured to execute communication in the primary selection communication group;
    a communication result acquisition unit (113) configured to acquire a communication result in the primary selection communication group;
    a communication environment determination unit (114) configured to determine a communication environment of the channel, based on the communication result; and
    a channel map update unit (115) configured to update a channel map indicating whether the channel is communicable, based on a result determined by the communication environment determination unit (114), wherein
    the communication environment determination unit (114) determines the communication environment of the channel, based on communication results of two primary selection communication groups to which the channel belongs.

2. The communication control device (100) according to claim 1, wherein
    the communication environment determination unit (114) determines that the communication environment of the channel is satisfactory when at least one of the communication results of the two primary selection communication groups to which the channel belongs is satisfactory.

3. The communication control device (100) according to claim 2, wherein

    when it is determined that the communication environment of the channel is not satisfactory, and the communication environment of the other channels in the two primary selection communication groups to which the channel belongs is not satisfactory, the channel setting unit (111) sets a second selection communication group including the channel and another channel that is determined to have a satisfactory communication environment by the communication environment determination unit (114),
the communication control unit (112) executes communication in the secondary selection communication group,
the communication result acquisition unit (113) acquires the communication result in the secondary selection communication group,
the communication environment determination unit (114) determines the communication environment of the channel, based on the communication result, and
the channel map update unit (115) updates the channel map indicating whether the channel is communicable, based on a result determined by the communication environment determination unit (114).

4. The communication control device (100) according to claim 3, wherein

    when a natural number m satisfies Expression (1) given below, a system error is detected, and control is performed to prevent the communication control unit (112) from executing communication,

$$m \geq (n+1)/2 \bullet\bullet\bullet (1)$$

    where
    n is a natural number indicating the number of channels, and
    m is a natural number indicating the number of channels that are not communicable and are indicated in the channel map.

5. A communication control system (10) comprising:

    a battery pack installed in a vehicle; and
    a communication control device (100) according to any one of claims 1 to 4.

6. A communication control method being executed by a computer to control wireless communication with a peripheral management device (200) in a battery pack installed in a vehicle, the communication control method being **characterized by** comprising:

    setting two channels as a primary selection communication group, the two channels being selected from a plurality of channels used for the wireless communication;
    executing communication in the primary selection communication group;

acquiring a communication result in the primary selection communication group;

determining a communication environment of the channel, based on the communication result; and

updating a channel map indicating whether the channel is communicable, based on a result being determined, wherein

the communication environment of the channel is determined based on communication results of two primary selection communication groups to which the channel belongs.

## Patentansprüche

1. Kommunikationssteuervorrichtung (100), die eingerichtet ist, drahtlose Kommunikation mit einer peripheren Verwaltungsvorrichtung (200) in einem Batteriepack zu steuern, der in einem Fahrzeug installiert ist, **dadurch gekennzeichnet, dass** sie umfasst:

eine Kanaleinstelleinheit (111), die eingerichtet ist, zwei Kanäle als eine Primärwahlkommunikationsgruppe einzustellen, wobei die zwei Kanäle aus einer Mehrzahl an Kanälen gewählt werden, die für die drahtlose Kommunikation verwendet werden;

eine Kommunikationssteuereinheit (112), die eingerichtet ist, Kommunikation in der Primärwahlkommunikationsgruppe auszuführen;

eine Kommunikationsergebnis-Erfassungseinheit (113), die eingerichtet ist, ein Kommunikationsergebnis in der Primärwahlkommunikationsgruppe zu erfassen;

eine Kommunikationsumgebungs-Bestimmungseinheit (114), die eingerichtet ist, eine Kommunikationsumgebung des Kanals zu bestimmen, auf Grundlage des Kommunikationsergebnisses; und

eine Kanalkarten-Aktualisierungseinheit (115), die eingerichtet ist, eine Kanalkarte, die anzeigt, ob der Kanal kommunizierbar ist, zu aktualisieren, auf Grundlage eines Ergebnisses, das von der Kommunikationsumgebungs-Bestimmungseinheit (114) bestimmt wird, wobei

die Kommunikationsumgebungs-Bestimmungseinheit (114) die Kommunikationsumgebung des Kanals auf Grundlage von Kommunikationsergebnissen von zwei Primärwahlkommunikationsgruppen bestimmt, zu denen der Kanal gehört.

2. Kommunikationssteuervorrichtung (100) nach Anspruch 1, wobei die Kommunikationsumgebungs-Bestimmungseinheit (114) bestimmt, dass die Kommunikationsumgebung des Kanals ausreichend ist, wenn mindestens eines der Kommunikationsergebnisse der zwei Primärwahlkommunikationsgruppen, zu der der Kanal gehört, ausreichend ist.

3. Kommunikationssteuervorrichtung (100) nach Anspruch 2, wobei wenn bestimmt wird, dass die Kommunikationsumgebung des Kanals nicht ausreichend ist, und die Kommunikationsumgebung der anderen Kanäle in den zwei Primärwahlkommunikationsgruppen, zu denen der Kanal gehört, nicht ausreichend ist, die Kanaleinstelleinheit (111) eine Zweitwahlkommunikationsgruppe einstellt, die den Kanal und einen anderen Kanal enthält, von dem von der Kommunikationsumgebungs-Bestimmungseinheit (114) bestimmt wird, dass er eine ausreichende Kommunikationsumgebung hat,

die Kommunikationssteuereinheit (112) Kommunikation in der Sekundärwahlkommunikationsgruppe ausführt,

die Kommunikationsergebnis-Erfassungseinheit (113) das Kommunikationsergebnis in der Sekundärwahlkommunikationsgruppe erfasst,

die Kommunikationsumgebungs-Bestimmungseinheit (114) die Kommunikationsumgebung des Kanals bestimmt, auf Grundlage des Kommunikationsergebnisses, und

die Kanalkarten-Aktualisierungseinheit (115) die Kanalkarte, die anzeigt, ob der Kanal kommunizierbar ist, auf Grundlage eines Ergebnisses aktualisiert, das von der Kommunikationsumgebungs-Bestimmungseinheit (114) bestimmt wird.

4. Kommunikationssteuervorrichtung (100) nach Anspruch 3, wobei

wenn eine natürliche Zahl m untenstehenden Ausdruck (1) erfüllt, ein Systemfehler erkannt wird, und Steuerung durchgeführt wird, um die Kommunikationssteuereinheit (112) daran zu hindern, Kommunikation auszuführen,

$$m \geq (n+1)/2 \cdots (1)$$

wobei

n eine natürliche Zahl ist, die die Anzahl an Kanälen anzeigt, und

m eine natürliche Zahl ist, die die Anzahl an Kanälen anzeigt, die nicht kommunizierbar sind und in der Kanalkarte angezeigt sind.

5. Kommunikationssteuersystem (10), umfassend:

einen Batteriepack, der in einem Fahrzeug installiert ist; und

eine Kommunikationssteuervorrichtung (100) nach einem der Ansprüche 1 bis 4.

6. Kommunikationssteuerverfahren, das von einem Computer ausgeführt wird, um drahtlose Kommunikation mit einer peripheren Verwaltungsvorrichtung (200) in einem Batteriepack, der in einem Fahrzeug installiert ist, zu steuern, wobei das Kommunikationssteuerverfahren **dadurch gekennzeichnet ist, dass** es umfasst:

Einstellen von zwei Kanälen als eine Primärwahlkommunikationsgruppe, wobei die zwei Kanäle aus einer Mehrzahl an Kanälen gewählt werden, die für die drahtlose Kommunikation verwendet werden;

Ausführen von Kommunikation in der Primärwahlkommunikationsgruppe;

Erfassen eines Kommunikationsergebnisses in der Primärwahlkommunikationsgruppe;

Bestimmen einer Kommunikationsumgebung des Kanals, auf Grundlage des Kommunikationsergebnisses; und

Aktualisieren einer Kanalkarte, die anzeigt, ob der Kanal kommunizierbar ist, auf Grundlage eines bestimmten Ergebnisses, wobei die Kommunikationsumgebung des Kanals auf Grundlage von Kommunikationsergebnissen von zwei Primärwahlkommunikationsgruppen bestimmt wird, zu denen der Kanal gehört.

## Revendications

1. Dispositif de commande de communication (100) configuré pour commander la communication sans fil avec un dispositif de gestion de périphériques (200) dans un bloc-batterie installé dans un véhicule, **caractérisé en ce qu'**il comprend :

une unité de réglage de canaux (111) configurée pour régler deux canaux comme groupe de communication de sélection primaire, les deux canaux étant sélectionnés parmi une pluralité de canaux utilisés pour la communication sans fil ;

une unité de commande de communication (112) configurée pour exécuter une communication dans le groupe de communication de sélection primaire ;

une unité d'acquisition de résultat de communication (113) configurée pour acquérir un résultat de communication dans le groupe de communication de sélection primaire ;

une unité de détermination d'environnement de communication (114) configurée pour déterminer un environnement de communication du canal, sur la base du résultat de communication ;

et

une unité de mise à jour de carte de canaux (115) configurée pour mettre à jour une carte de canaux indiquant si le canal est apte à la communication, sur la base d'un résultat déterminé par l'unité de détermination d'environnement de communication (114), dans lequel l'unité de détermination de l'environnement de communication (114) détermine l'environnement de communication du canal, sur la base de résultats de communication de deux groupes de communication de sélection primaire auxquels appartient le canal.

2. Dispositif de commande de communication (100) selon la revendication 1, dans lequel l'unité de détermination d'environnement de communication (114) détermine que l'environnement de communication du canal est satisfaisant lorsqu'au moins l'un des résultats de communication des deux groupes de communication de sélection primaire auxquels appartient le canal est satisfaisant.

3. Dispositif de commande de communication (100) selon la revendication 2, dans lequel

lorsqu'il est déterminé que l'environnement de communication du canal n'est pas satisfaisant, et que l'environnement de communication des autres canaux dans les deux groupes de communication de sélection primaire auxquels appartient le canal n'est pas satisfaisant, l'unité de réglage de canaux (111) règle un second groupe de communication de sélection comprenant le canal et un autre canal qui est déterminé comme ayant un environnement de communication satisfaisant par l'unité de détermination d'environnement de communication (114),

l'unité de commande de communication (112) exécute la communication dans le groupe de communication de sélection secondaire,

l'unité d'acquisition de résultat de communication (113) acquiert le résultat de communication dans le groupe de communication de sélection secondaire,

l'unité de détermination d'environnement de communication (114) détermine l'environnement de communication du canal, sur la base du résultat de communication, et

l'unité de mise à jour de carte de canaux (115) met à jour la carte de canaux indiquant si le canal est apte à la communication, sur la base d'un résultat déterminé par l'unité de détermination d'environnement de communication (114).

4. Dispositif de commande de communication (100) selon la revendication 3, dans lequel

lorsqu'un nombre naturel m satisfait à l'Expression (1) ci-dessous, une erreur système est détectée et une commande est effectuée pour empêcher l'unité de commande de communication (112) d'exécuter une communication,

$$m \geq (n+1)/2 \cdots (1)$$

où
n est un nombre naturel indiquant le nombre de canaux, et
m est un nombre naturel indiquant le nombre de canaux qui ne sont pas aptes à la communication et qui sont indiqués dans la carte de canaux.

5. Système de commande de communication (10) comprenant :

un bloc-batterie installé dans un véhicule ; et
un dispositif de commande de communication (100) selon l'une quelconque des revendications 1 à 4.

6. Procédé de commande de communication qui est exécuté par un ordinateur pour commander la communication sans fil avec un dispositif de gestion de périphériques (200) dans un bloc-batterie installé dans un véhicule, le procédé de commande de communication étant **caractérisé en ce qu'**il comprend :

le réglage de deux canaux comme groupe de communication de sélection primaire, les deux canaux étant sélectionnés parmi une pluralité de canaux utilisés pour la communication sans fil ;
l'exécution d'une communication dans le groupe de communication de sélection primaire ;
l'acquisition d'un résultat de communication dans le groupe de communication de sélection primaire ;
la détermination d'un environnement de communication du canal, sur la base du résultat de communication ; et
la mise à jour d'une carte de canaux indiquant si le canal est apte à la communication, sur la base d'un résultat qui est déterminé, dans lequel l'environnement de communication du canal est déterminé sur la base de résultats de communication de deux groupes de communication de sélection primaire auxquels appartient le canal.

FIG. 1

# FIG. 2

# FIG. 3

100

110

## CONTROL UNIT

111

### CHANNEL SETTING UNIT

112

### COMMUNICATION CONTROL UNIT

113

### COMMUNICATION RESULT ACQUISITION UNIT

114

### COMMUNICATION ENVIRONMENT DETERMINATION UNIT

115

### CHANNEL MAP UPDATE UNIT

116

### SYSTEM ERROR DETECTION UNIT

120

## STORAGE UNIT

121

### CHANNEL MAP INFORMATION DB

122

### COMMUNICATION ENVIRONMENT INFORMATION DB

# FIG. 4

EP 4 633 221 B1

# FIG. 5

122

| | FIRST GROUP | SECOND GROUP | DETERMINATION RESULT | RE-EXECUTION CHANNEL PAIR | RE-DETERMINATION RESULT |
|---|---|---|---|---|---|
| ch0 | ○ | ○ | Good | | |
| ch1 | ○ | × | Good | | |
| ch2 | × | × | NG | | |
| ch3 | × | ○ | Good | | |
| ch4 | ○ | × | Good | | |
| ch5 | × | × | NG | | |
| ch6 | × | × | NG | ch31 | Good |
| ch7 | × | × | NG | | |
| ... | ... | ... | ... | ... | ... |
| ch31 | ○ | ○ | Good | | |
| ch32 | ○ | ○ | Good | | |
| ch33 | ○ | × | Good | | |
| ch34 | × | × | NG | | |
| ch35 | × | ○ | Good | | |
| ch36 | ○ | ○ | Good | | |

# FIG. 6

# FIG. 7

START

SET CHANNEL — S701

CONTROL COMMUNICATION — S702

ACQUIRE COMMUNICATION RESULT — S703

DETERMINE COMMUNICATION ENVIRONMENT — S704

S705

DETERMINATION IS TERMINATED? — NO

YES

UPDATE CHANNEL MAP — S706

END

**EP 4 633 221 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024007900 A
- US 2022253650 A1
- WO 2023243420 A1